(19) **Europäisches Patentamt**
**European Patent Office**
**Office européen des brevets**

(11) **EP 2 741 522 A1**

(12) **EUROPEAN PATENT APPLICATION**

(43) Date of publication:
**11.06.2014 Bulletin 2014/24**

(21) Application number: **14157892.2**

(22) Date of filing: **14.10.2004**

(51) Int Cl.:
*H04R 1/00* (2006.01)   *H04R 1/08* (2006.01)
*H04R 1/02* (2006.01)

(84) Designated Contracting States:
**AT BE BG CH CY CZ DE DK EE ES FI FR GB GR HU IE IT LI LU MC NL PL PT RO SE SI SK TR**

(30) Priority: **14.10.2003 US 686036**

(62) Document number(s) of the earlier application(s) in accordance with Art. 76 EPC:
**04795110.8 / 1 685 740**

(71) Applicant: **Gore Enterprise Holdings, Inc.**
**Newark, DE 19714-9206 (US)**

(72) Inventors:
• **Banter, Chad A.**
**Bear, DE Delaware 19701 (US)**

• **Reis, Bradley E.**
**West Lake, OH Ohio 44145 (US)**

(74) Representative: **Shanks, Andrew**
**Marks & Clerk LLP**
**Aurora**
**120 Bothwell Street**
**Glasgow G2 7JS (GB)**

<u>Remarks:</u>
This application was filed on 05-03-2014 as a divisional application to the application mentioned under INID code 62.

(54) **Protective cover assembly**

(57)   A protective cover assembly including a metal foil with perforations, and a treatment on one or more surfaces of said metal foil. The treatment is a hydrophobic or oleophobic treatment, or both. The protective cover assembly has an average specific acoustic resistance of less than about 11 Rayls MKS from 250-300 Hz, an average specific acoustic reactance magnitude of less than about 1 Rayls MKS from 250-300 Hz, and an instantaneous water entry pressure value of greater than about 11 cm. The perforations of the metal foil preferably have an average maximum pore size of less than about micrometers. The protective cover assembly further includes an adhesive mounting system, and the preferred metal foil is nickel.

FIG. 1a

EP 2 741 522 A1

**Description**

**RELATED APPLICATIONS**

This application is a continuation-in-part of U.S. Application Serial Number 10/686,036, now pending, which is incorporated herein in its entirety.

**FIELD OF THE INVENTION**

The present invention generally relates to a cover providing environmental protection for a device, particularly an electronic device. More specifically, the present invention relates to a protective cover assembly comprising a treated perforated metal foil that has low specific acoustic resistance and reactance, low air flow resistance, high EMI shielding effectiveness, occupies limited space and has the ability to withstand exposure to dust and liquid intrusion.

**BACKGROUND OF THE INVENTION**

Most modem electronic devices, such as radios and cellular telephones, contain at least one component that needs to be protected from external contamination, such as liquids or dust An acoustic transducer such as a microphone, ringer, speaker, or buzzer is an example of a component that requires such protection. An acoustic transducer is an electrical component that converts electrical signals into sound, or vice-versa. Acoustic transducers are easily susceptible to being physically damaged, so they are often mounted in a protective housing with apertures located over the position of the acoustic transducer. These apertures enable the system to transmit or receive sound signals with minimal acoustic loss, while simultaneously preventing large debris from entering the housing and damaging the acoustic transducer. These apertures, however, do not protect the acoustic transducer from incidental exposure to liquids (e.g., spills, rain, etc.) or fine dust and other particulate. To protect acoustic transducers from contaminants such as these, a protective cover is typically utilized between the acoustic transducer and the housing, as a supplemental barrier to the apertures. A protective cover is thus simply a device that is intended to prevent unwanted contamination (liquid, particulate, or both) from reaching a susceptible component. For acoustic applications, it is desirable for the protective cover assembly to accomplish this contamination protection while minimizing the overall impact to the acoustic loss of the system.

An acoustic transducer, as well as other components in an electronic device are also often susceptible to externally-generated EMI (electromagnetic interference) or ESD (electrostatic discharge). An unshielded electronic device can allow EMI to penetrate the device's housing, causing it function improperly. Additionally, a poorly protected electronic device can allow ESD to permanently damage certain sensitive components within the device. Shielding from EMI and ESD is typically accomplished by properly grounding components, and/or by providing a Faraday cage (or EMI shield) around these susceptible components. Since an EMI shield is, in essence, a metal or electrically conductive enclosure that surrounds the components, it will typically block or attenuate sound signals when shielding an acoustic transducer. In such situations, large holes or apertures in the EMI shield will lower the acoustic loss (thereby creating less attenuation) but it will also decrease the EMI shield's shielding effectiveness, as well as allow liquids, dust, and other contamination to penetrate the housing and reach the susceptible components. The properties of EMI and ESD protection, as well as contamination protection, are often therefore, competing properties. Accordingly, there exists a need in industry for a protective cover assembly that effectively blocks or limits EMI and ESD, has low acoustic loss, and prevents contamination from entering an electronic device's housing.

Many electronic components, such as notebook computers, digital projectors, etc. also generate heat which must be dissipated. It is important to keep the internal temperatures of these electronic devices low because the failure rate of electronic components within them typically increase with higher temperatures. Many electronic devices use an electric fan to increase the air flow across the electronic components, thereby cooling them. These systems typically require holes or apertures in the housing to allow for cool air to be drawn in, and the heated air to be expelled. Larger holes will decrease the air flow resistance (thereby increasing the cooling effectiveness), but will also allow more opportunity for unwanted liquids and dust particles to enter the device's housing and cause potential damage to susceptible components.

Accordingly, there exists a need in industry for a protective cover that provides low air flow resistance, effectively blocks or limits EMI and ESD, has low acoustic loss, and prevents contamination from entering the device's housing.

Fortunately, a protective cover that has low air flow resistance will typically also contribute little to the acoustic loss of a system. The acoustic loss of a system (typically measured in decibels) is based on the characteristic elements/components that comprise the system, such as the housing aperture size, the volume of the cavity between the acoustic transducer and the protective cover, etc. The impact each element has on the overall acoustic loss of the system, independent of its area, can be determined individually by calculation or test; and this is called specific acoustic impedance.

For most acoustic systems, the ideal protective cover would have a specific acoustic impedance value as small as possible. In some cases, however, the acoustic system (minus the protective cover) may contain sharp resonances at certain frequencies. In this case, a protective cover with a higher level of specific acoustic impedance can be effective at dampening the system resonances and ultimately flatten the spectrum for improved sound quality.

Specific acoustic impedance can be measured in Rayls (MKS), and is composed of two terms: specific acoustic resistance and specific acoustic reactance. Specific acoustic resistance affects the specific acoustic impedance in a uniform manner across the frequency spectrum, and is related to viscous losses as air particles pass through any pores in the protective cover. These viscous losses are created by either friction of the air particle on the pore walls and/or a less direct air particle path (i.e. tortuous). Specific acoustic reactance, however, tends to affect the specific acoustic impedance in a more frequency-dependent manner, and is related to the movement/vibration of the protective cover in use. Because it has a non-uniform behavior with frequency, materials that are highly reactive are typically not selected for use as a protective cover, unless the application requires high environmental protection.

As a general rule, the larger the pore size that exists in a protective cover (all else being equal), the lower the resulting specific acoustic resistance, the lower the air flow resistance, and the lower the level of liquid and particulate protection. Also generally speaking, the thinner the protective cover, the lower the specific acoustic resistance, as well. This is because, as the protective cover becomes thinner, lower viscous losses associated with air particles passing through the pores result. Non-porous covers, or ones with very tight pore structures, however, tend to transmit sound via mechanical vibration of the protective cover (i.e. reactance), as opposed to physically passing air particles through the pores. Since vibration is required to transmit sound in this case, protective covers with high flexibility, low mass and less thickness are desired, in order to minimize specific acoustic reactance. These thin, low mass protective covers, however, can be more delicate, less durable, and more difficult to handle during fabrication and subsequent installation into an electronic device, so very low reactance may not be achievable in practice. The fact that the properties of specific acoustic resistance, specific acoustic reactance, durability, manufacturability, and contamination protection are often competing have made it difficult to develop protective covers that simultaneously meet aggressive acoustic, air flow, liquid and particulate protection targets. This has resulted in two major categories of protective covers: ones that can give high liquid and particulate protection, but with a relatively high air flow resistance and specific acoustic impedance (usually dominated by reactance); and ones that offer low air flow resistance and specific acoustic impedance, but with an accompanying low level of liquid and particulate protection.

There are several different materials used in the construction of typical protective covers in use today. Many prior art protective covers are composed of a porous material constructed of synthetic or natural fibers, formed into either a woven or non-woven pattern. Other protective covers, such as microporous PTFE membranes, contain a network of interconnected nodes and fibrils. Finally, for very harsh or demanding environmental applications, some protective covers are composed entirely of non-porous films, such as polytetrafluoroethylene ("PTFE"), polyurethane, Mylar®, etc.

A general description of prior art patents adhering to the above-described scientific principles follows.

U.S. Pat. No. 4,949,386, entitled "Speaker System", teaches a protective cover comprising in part, a laminated two-layer construction defined by a polyester woven or non-woven material and a microporous PTFE membrane. The hydrophobic property of the microporous PTFE membrane prevents liquid from passing through the environmental barrier system. However, although this laminated covering system may be effective in preventing liquid entry into an electronic device, the lamination results in an excessively high specific acoustic impedance (dominated by reactance) which is unacceptable in modern communication electronics where sound quality is a critical requirement.

U.S. Pat. No. 4,987,597 entitled "Apparatus For Closing Openings Of A Hearing Aid Or An Ear Adapter For Hearing Aids" teaches the use of a microporous PTFE membrane as a protective cover. The membrane effectively restricts liquid passage through the membrane but also results in a high specific acoustic impedance. Additionally, the patent fails to specifically teach the material parameters of the membrane that are required in order to achieve low specific acoustic impedance, although it does generally describe the parameters in terms of porosity and air permeability.

U.S. Pat. No. 5,420,570 entitled "Manually Actuable Wrist Alarm Having A High-Intensity Sonic Alarm Signal" teaches the use of a non-porous film as a protective cover. As previously discussed, although a non-porous film can provide excellent liquid protection, such a non-porous film suffers from extremely high specific acoustic impedance, which is dominated by reactance. This can produce sound that is excessively muffled and distorted. The high specific acoustic reactance results from the relatively high mass and stiffness associated with typical non-porous films.

U.S. Pat. No. 4,071,040, entitled "Water-Proof Air Pressure Equalizing Valve," teaches the disposition of a thin microporous membrane between two sintered stainless steel disks. Although such a construction may have been effective for its intended use in rugged military-type field telephone sets, it is not desirable for use in modern communication electronic devices because the reactance is extremely high. This is because the two stainless steel disks physically constrain the membrane, limiting its ability to vibrate. Additionally, sintered metal disks are relatively thick and heavy and are thus impractical for lightweight, handheld portable electronic devices.

To overcome some of the shortcomings described above with respect to the '386, '597, '570 and '040 patents, U.S. Patent No. 5,828,012, entitled "Protective Cover Assembly Having Enhanced Acoustical Characteristics" teaches a protective cover comprising a membrane that is bonded to a porous support layer in a ring-like pattern. The construction results in an inner, unbonded region surrounded by an outer, bonded region. In this configuration, the membrane layer and the support layer are free to independently vibrate in response to acoustic energy passing therethrough, thereby minimizing the specific acoustic reactance over a completely laminated structure. However, although this construction reduces the reactance of the laminate comparatively, the degree of specific acoustic reactance still remains quite high.

To increase the simplicity, robustness, and improve the liquid protection of the construction described above with respect to the '012 patent, U.S. Patent Nos. 6,512,834 entitled "Protective Acoustic Cover Assembly" teaches a protective cover that eliminates the need for a porous support layer. While this invention provides both improved water intrusion performance and acoustics over the '012 construction, the acoustic reactance still dominates the acoustic impedance.

Although the prior art mentioned above primarily discusses highly reactive materials, most commercially available protective covers are typically resistive. Examples of such resistive materials are a polyester woven material with the tradename SAATIFIL ACOUSTEX™ by SaatiTech, a division of the Saati Group, Inc. and nonwoven materials from Freudenberg Nonwovens NA and W. L. Gore & Associates, Inc. As mentioned previously, these materials can have a high specific acoustic resistance, which can be influenced by either their tortuous particle path and/or their increased material thickness. These physical material properties create higher viscous losses associated with the air particles passing through the pores. Because highly resistive materials are often highly undesirable in many applications, materials of this type can be produced with lower specific acoustic resistance, but this is usually accomplished by increasing the pore size of the material. This results in a decrease in the level of liquid and particulate protection.

Because the consumer market desires the use of handheld electronic devices in increasingly harsh environments while simultaneously expecting high reliability and sound quality, the demand for durable, more contamination-resistant and less resistive/reactive protective covers has increased remarkably. In addition, as electronic devices become more portable and smaller, the heat load inside the enclosure increases thus increasing the need for ventilation. Therefore, there exists an unmet need to have a protective cover with low acoustic resistance, low air flow resistance, no measurable acoustic reactance, and a high level of water and particulate protection. The protective cover should also be durable and sufficiently rigid to facilitate the use of quick and accurate installation methods. It would also be highly desirable for the protective cover to offer additional properties and benefits such as: electrical conductivity for EMI shielding, grounding and ESD protection, high temperature and chemical resistance, and compatibility with insert-molding or heat-staking processes to simplify installation into a housing.

The foregoing illustrates limitations known to exist in present protective covers for electronic and other devices. Thus, it is apparent that it would be advantageous to provide an improved protective cover to overcome one or more of the limitations set forth above. Accordingly, a suitable alternative is provided including features more fully disclosed hereinafter.

## SUMMARY OF THE INVENTION

The present invention provides a protective cover assembly including a metal foil with perforations, and a treatment on one or more surfaces of said metal foil. The treatment is a modification of the surface of the foil to render it hydrophobic or oleophobic, or both. The protective cover assembly preferably has an average specific acoustic resistance of less than about 11 Rayls MKS from 250-300 Hz, an average specific acoustic reactance magnitude of less than about 1 Rayls MKS from 250-300 Hz, an air flow resistance of less than about 0.05 mm $H_2O$, and an instantaneous water entry pressure value of greater than about 11 cm. The perforations of the metal foil preferably have an average maximum pore size of less than about 150 micrometers, and more preferably less than 100 micrometers. The protective cover assembly may further include an adhesive mounting system, and the preferred metal foil is nickel. The preferred thickness of the metal foil is less than about 20 micrometers.

In another aspect, the present invention provides an apparatus including:

(a) an electronic component;
(b) a housing having at least one aperture, the housing at least partially enclosing the electronic component; and
(c) a protective cover assembly disposed proximate the electronic component, the protective cover assembly including:

(i) a metal foil with perforations, and
(ii) a treatment on one or more surfaces of the metal foil.

In this aspect, the protective cover assembly is integral with the housing absent any adhesive, for example by insert molding.

In another aspect, the invention provides a method of protecting an electronic component disposed in a housing having an aperture by:

(a) providing a protective cover assembly comprising:

(i) a metal foil with perforations, and
(ii) a treatment on one or more surfaces of the metal foil;

(b) mounting the protective cover assembly proximate the electronic component to protect the electronic component from particulates and liquid ingress.

The invention will now be further described by reference to the following clauses.

According to a first clause there is provided a protective cover assembly comprising:

(i) a metal foil with perforations, and
(ii) a treatment on one or more surfaces of said metal foil, wherein said protective cover assembly has an air flow resistance of about 0.05 mm of $H_2O$ or less.

According to a second clause there is provided the protective cover assembly of the first clause, wherein said protective cover assembly has an instantaneous water entry pressure value of greater than about 11 cm.

According to a third clause there is provided the protective cover assembly of the first clause, wherein said protective cover assembly has a shielding effectiveness of greater than about 50 decibels at 1 GHz.

According to a fourth clause there is provided the protective cover assembly of the first clause wherein said perforations have an average maximum pore size of less than about 150 micrometers.

According to a fifth clause there is provided the protective cover assembly of the first clause wherein said perforations have an average maximum pore size of less than about 100 micrometers.

According to a sixth clause there is provided the protective cover assembly of the first clause wherein said perforations have an average maximum pore size of between about 50 and 100 micrometers.

According to a seventh clause there is provided the protective cover assembly of the first clause wherein said treatment is a hydrophobic treatment.

According to an eighth clause there is provided the protective cover assembly of the seventh clause wherein said hydrophobic treatment comprises silica particles.

According to a ninth clause there is provided the protective cover assembly of the first clause wherein said treatment is an oleophobic treatment.

According to a tenth clause there is provided the protective cover assembly of the first clause wherein said protective cover assembly is less than 12 micrometers thick.

According to an eleventh clause there is provided the protective cover assembly of the first clause further comprising an adhesive mounting system.

According to a twelfth clause there is provided the protective cover assembly of the first clause wherein said metal foil is nickel.

According to a thirteenth clause there is provided a protective cover assembly comprising:

(i) a metal foil with perforations, and
(ii) a treatment on one or more surfaces of said metal foil,

wherein said protective cover assembly has an instantaneous water entry pressure value of greater than about 11 cm; and
wherein said protective cover assembly has an air flow resistance of about 0.05 mm of $H_2O$ or less; and
wherein said perforations have an average maximum pore size of less than about 150 micrometers; and
wherein said metal foil is nickel.

According to a fourteenth clause there is provided an apparatus comprising:

(a) an electronic component transducer;
(b) a housing having at least one aperture, said housing at least partially enclosing said electronic component;
(c) a protective cover assembly disposed proximate said electronic component, said protective cover assembly comprising:

(i) a metal foil with perforations,
(ii) a treatment on one or more surfaces of said metal foil, and
(iii) an air flow resistance of about 0.05 mm of $H_2O$ or less.

According to a fifteenth clause there is provided the apparatus of the fourteenth clause, wherein said perforations of said metal foil have an average maximum pore size of less than about 150 micrometers, and

(i) said treatment on one or more surfaces of said metal foil is a hydrophobic or oleophobic treatment.

According to a sixteenth clause there is provided a method of protecting an electronic component disposed in a housing having an aperture comprising the steps of:

(a) providing a protective cover assembly comprising:

(i) a metal foil with perforations,
(ii) a treatment on one or more surfaces of said metal foil; and
(iii) an air flow resistance of about 0.05 mm of $H_2O$ or less.

(b) mounting said protective cover assembly proximate said electronic component to protect said electronic component from particulates and liquid ingress.

According to a seventeenth clause there is provided a protective cover assembly comprising:

(i) a metal foil with perforations, and
(ii) a treatment on one or more surfaces of said metal foil, wherein said protective cover assembly has an average specific acoustic resistance of less than about 64 Rayls MKS from 250- 300 Hz.

According to an eighteenth clause there is provided the protective cover assembly of the seventeenth clause, wherein said protective cover assembly has an average specific acoustic resistance of less than about 11 Rayls MKS from 250-300 Hz.
According to a nineteenth clause there is provided the protective cover assembly of the seventeenth clause, wherein said protective cover assembly has an average specific acoustic reactance magnitude of less than about 7 Rayls MKS from 250-300 Hz.
According to a twentieth clause there is provided the protective cover assembly of the seventeenth clause, wherein said protective cover assembly has an average specific acoustic reactance magnitude of less than about 1 Rayls MKS from 250-300 Hz.
According to a twenty-first clause there is provided the protective cover assembly of the seventeenth clause, wherein said protective cover assembly has an instantaneous water entry pressure value of greater than about 11 cm.
According to a twenty-second clause there is provided the protective cover assembly of the seventeenth clause wherein said perforations have an average maximum pore size of less than about 150 micrometers.
According to a twenty-third clause there is provided the protective cover assembly of the seventeenth clause wherein said treatment is a hydrophobic treatment.
According to a twenty-fourth clause there is provided the protective cover assembly of the seventeenth clause wherein said treatment is an oleophobic treatment.
According to a twenty-fifth clause there is provided the protective cover assembly of the seventeenth clause further comprising an adhesive mounting system.
According to a twenty-sixth clause there is provided the protective cover assembly of the seventeenth clause wherein said metal foil is nickel.
According to a twenty-seventh clause there is provided a protective cover assembly comprising:

(i) a metal foil with perforations, and
(ii) a treatment on one or more surfaces of said metal foil,

wherein said protective cover assembly has an average specific acoustic resistance of less than about 11 Rayls MKS from 250-300 Hz, an average specific acoustic reactance magnitude of less than about 1 Rayls MKS from 250-300 Hz, an instantaneous water entry pressure value of greater than about 11 cm; and
wherein said perforations have an average maximum pore size of less than about 150 micrometers; and wherein said metal foil is nickel.
According to a twenty-eighth clause there is provided an apparatus comprising:

(a) an acoustic transducer;
(b) a housing having at least one aperture, said housing at least partially enclosing said acoustic transducer; (c) a protective cover assembly disposed proximate said aperture between said acoustic transducer and said housing,

said protective cover assembly comprising:

(i) a metal foil with perforations, and
(ii) a treatment on one or more surfaces of said metal foil, wherein said protective cover assembly has an average specific acoustic resistance of less than about 64 Rayls MKS from 250-300 Hz.

According to a twenty-ninth clause there is provided the apparatus of the twenty-eighth clause, wherein said protective cover assembly has an average specific acoustic reactance magnitude of less than about 1 Rayls MKS from 250-300 Hz.

According to a thirtieth clause there is provided the apparatus of the twenty-eighth clause, wherein said protective cover assembly has an instantaneous water entry pressure value of greater than about 11 cm.

According to a thirty-first clause there is provided the apparatus of the twenty-eighth clause wherein said perforations have an average maximum pore size of less than about 150 micrometers.

According to a thirty-second clause there is provided the apparatus of the twenty-eighth clause wherein said treatment is a hydrophobic treatment.

According to a thirty-third clause there is provided the apparatus of the twenty-eighth clause wherein said treatment is an oleophobic treatment.

According to a thirty-fourth clause there is provided the apparatus of the twenty-eighth clause wherein said protective cover assembly further comprises an adhesive mounting system.

According to a thirty-fifth clause there is provided the apparatus of the twenty-eighth clause wherein said metal foil is nickel.

According to a thirty-sixth clause there is provided the apparatus of the twenty-eighth clause, wherein said protective cover assembly is integral with said housing absent any adhesive.

According to a thirty-seventh clause there is provided an apparatus comprising:

(a) an acoustic transducer;
(b) a housing having at least one aperture, said housing at least partially enclosing said acoustic transducer;
(c) a protective cover assembly disposed proximate said aperture between said acoustic transducer and said housing, said protective cover assembly comprising:

(i) a metal foil with perforations having an average maximum pore size of less than about 150 micrometers, and
(ii) a hydrophobic or oleophobic treatment on one or more surfaces of said metal foil;
(iii) an average specific acoustic resistance of less than about 11 Rayls MKS from 250-300 Hz;
(iv) an average specific acoustic reactance magnitude of less than about 1 Rayls MKS from 250-300 Hz; and
(v) an instantaneous water entry pressure value of greater than about 11 cm.

According to a thirty-eighth clause there is provided a method of protecting an acoustic transducer disposed in a housing having an aperture comprising the steps of:

(a) providing a protective cover assembly disposed proximate said aperture between said acoustic transducer and said housing, said protective cover assembly comprising:

(i) a metal foil with perforations, and
(ii) a treatment on one or more surfaces of said metal foil;

(c) mounting said protective cover assembly adjacent said aperture to protect said acoustic transducer from particulates and liquid ingress.

According to a thirty-ninth clause there is provided the method of the thirty-eighth clause wherein said metal foil is nickel.

According to a fortieth clause there is provided the method of the thirty-eighth clause wherein said perforations have an average maximum pore size of less than about 150 micrometers.

According to a forty-first clause there is provided the method of the thirty-eighth clause wherein said protective cover assembly has an instantaneous water entry pressure value of greater than about 11 cm.

## BRIEF DESCRIPTION OF THE DRAWINGS

Fig. 1A is a plan view of a protective cover assembly according to an exemplary embodiment of the invention.

Fig. 1B is a side view of the protective cover assembly of Fig. 1A.

Fig. 2 is a view of the external side of a cellular phone housing according to an exemplary embodiment of the invention.

Fig. 3 is a view of the internal side of a cellular phone housing according to an exemplary embodiment of the invention.

Fig. 4A is a plan view of a protective cover assembly according to an exemplary embodiment of the invention.

Fig. 4B is a side view of the protective cover assembly of Fig. 4A.

Fig. 5A is a plan view of a protective cover assembly according to an exemplary embodiment of the invention.

Fig. 5B is a side view of the protective cover assembly of Fig. 5A.

Fig. 6A is a plan view of a protective cover assembly according to an exemplary embodiment of the invention.

Fig. 6B is a side view of the protective cover assembly of Fig. 6A.

Fig. 7A is a plan view of a protective cover assembly according to an exemplary embodiment of the invention.

Fig. 7B is a side view of the protective cover assembly of Fig. 7A.

Fig. 8A is a plan view of a protective cover assembly according to an exemplary embodiment of the invention.

Fig. 8B is a side view of the protective cover assembly of Fig. 8A.

Fig. 9A is a plan view of a protective cover assembly according to an exemplary embodiment of the invention.

Fig. 9B is a side view of the protective cover assembly of Fig. 9A.

Fig. 10A is a cross-sectional view of an electronic device according to an exemplary embodiment of the present invention.

Fig. 10B is a perspective view of a digital projector according to an exemplary embodiment of the present invention.

Fig. 10C is a perspective view of a notebook computer according to an exemplary embodiment of the present invention.

Fig. 11 is a schematic of a test device used to measure acoustic transmission loss.

Fig. 12 is a schematic of a test device used to measure instantaneous water entry pressure.

Fig. 13 is a graph showing the shielding effectiveness of an exemplary embodiment of the present invention.

## DETAILED DESCRIPTION OF THE INVENTION

Referring now to the drawings, wherein similar reference characters designate corresponding parts throughout the several views, embodiments of the perforated acoustic cover assembly of the present invention are generally shown in a variety of configurations and dimensioned for use, in one embodiment, to cover a transducer in a typical electronic device, such as a cellular phone. As should be understood, the present invention is not limited to the embodiments illustrated herein, as they are merely illustrative and can be modified or adapted without departing from the scope of the appended claims.

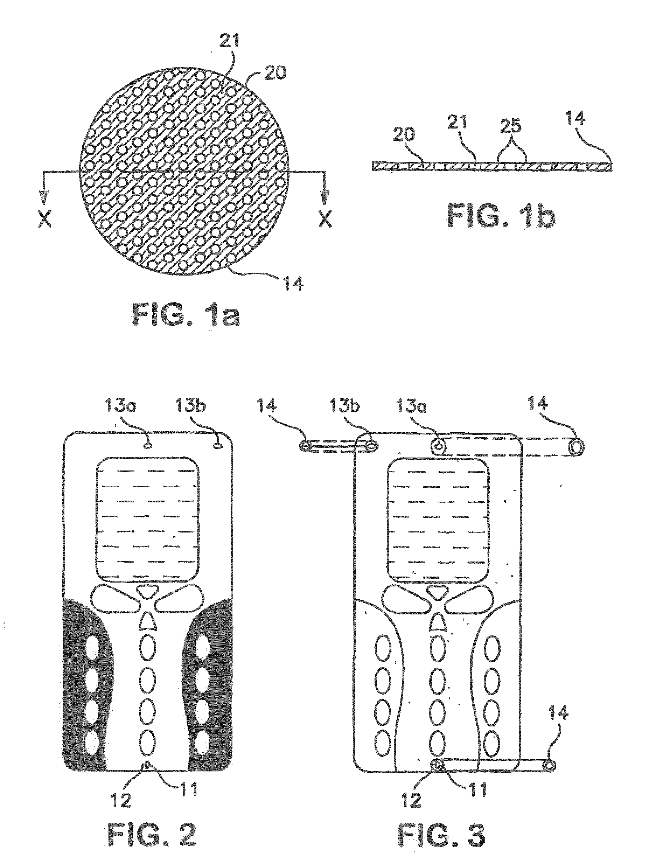

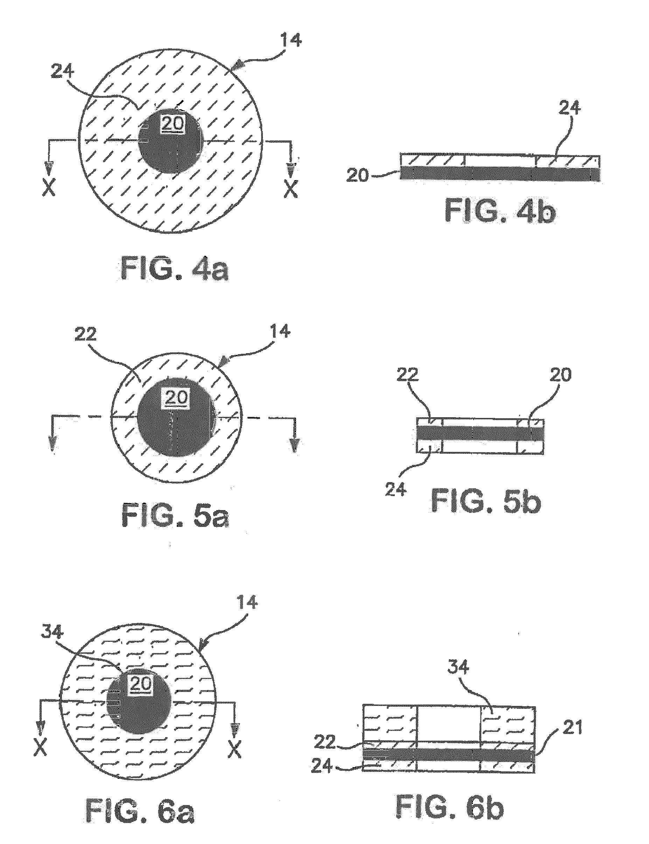

FIGS. 1a and 1b show a protective cover assembly 14, according to a preferred embodiment of the invention. The protective cover assembly 14 is comprised of a metal foil 20 with perforations 21 and a hydrophobic or oleophobic treatment 25 on one or more of its surfaces. The protective cover assembly 14 may also comprise a supplementary means of mounting, as shown in FIG. 4a-10b). The metal foil 20 can be made of any metal, including but not limited to: nickel, aluminum, copper, silver, lead, platinum, iron, steel, chromium or alloys thereof. A metal such as nickel is preferred for its high electrical conductivity, ability to resist oxidation, mechanical robustness and strength, high temperature resistance, ability to be manufactured via a continuous electroforming process, and other advantageous processing characteristics.

The metal foil 20 should be as thin as possible, while still maintaining physical robustness and ability to be manufactured and installed without damage. The thickness of the foil should be in the range of about 5 to 200 micrometers, and most preferably in the range 10 to 33 micrometers. The perforations 21 in the metal foil 20 should have a maximum pore size (i.e. maximum opening distance within the perforation) in the range of 10 to 1000 micrometers, preferably below 150 micrometers, more preferably below 100 micrometers, and most preferably in the range of about 50 to 100 micrometers, for applications requiring both low acoustic impedance and high environmental protection. The perforations 21 may be any shape, but are preferably round, oval, or hexagonal shaped. For most applications, the perforations 21 should preferably be as uniform and equidistant as possible across the metal foil 20 surface, and comprise a percent open area (i.e. the open pore area divided by the total sample area in percentage terms) of less than 65 percent, most preferably in the range of 5 to 45 percent. For applications where a higher resistance is desirable to dampen resonances, perforation sizes and percent open areas may be smaller.

The metal foil 20 with perforations 21 may be manufactured by any of a number of known processes, which produce the perforations 21 in either a separate step after foil production (such as through mechanical punching, laser drilling, photoetching, etc.), or in-situ during the foil production itself (for example by stretching or drawing processes, powder sintering processes, electroforming processes, etc.). An electroforming process is a preferred embodiment for fabrication of the metal foil 20 with perforations 21, since it has the capability of being continuous in nature, thereby allowing for subsequent, cost-effective roll-to-roll processing of the metal foil 20. Electroforming also has the advantage of being able to produce large volumes of perforations, in various shapes and locations, with high uniformity, and at high speeds. Methods to produce such products are disclosed in U.S. Pat Nos. 4,844,778 and other patents, can be used.

Still referring to FIGS. 1a and 1b, the metal foil 20 has a hydrophobic (i.e. water-repellant) and/or oleophobic (i.e. oil-repellant) treatment 25 on at least one of its surfaces, to improve its resistance to liquids such as water, oils, or other low surface tension liquids. For example, the water- and oil-repellent treatments and methods disclosed in U.S. Pat. Nos. 5,116,650, 5,286,279, 5,342,434, 5,376,441 and other patents, can be used. Other oleophobic treatments utilize coatings of fluorinated polymers such as, but not limited to: dioxole/TFE copolymers as those taught in U.S. Patents Nos. 5,385,694 and 5,460,872, perfluoroalkyl acrylates and perfluoroalkyl methacrylates such as those taught in U.S. Patent No. 5,462,586, and fluoro-olefins and fluorosilicones. If it is a hydrophobic treatment, it may include use of hydrophobic nanoparticle silica particles. Alternatively, treatment 25 is a surface modification such as by plasma exposure. The treatments described herein in combination with the perforation size, shape, percent open area, and thickness of the metal foil interact to determine the final performance characteristics of the protective cover assembly. Accordingly, these features may be varied to optimize the final performance (e.g., acoustic resistance versus liquid protection) depending on the application requirements.

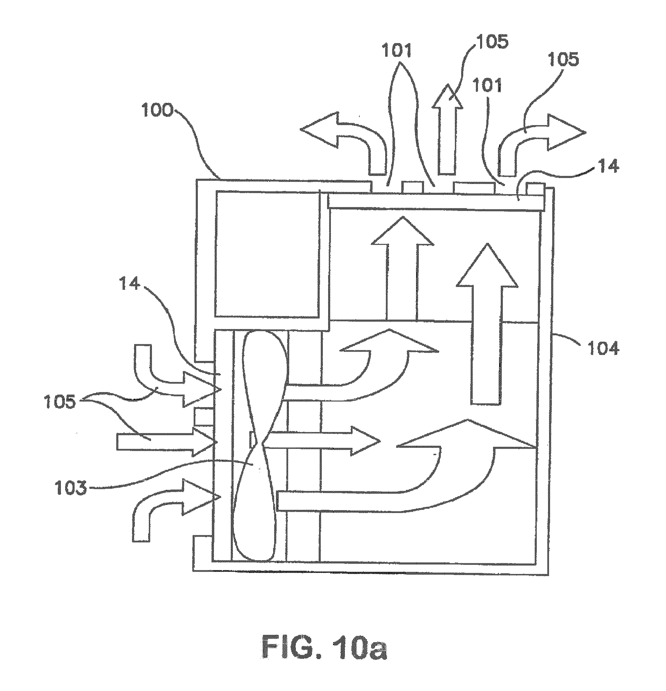

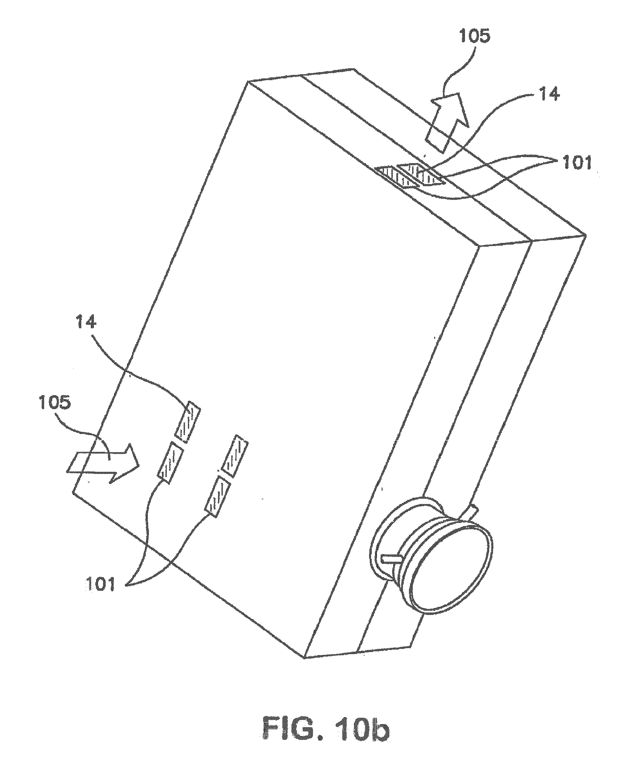

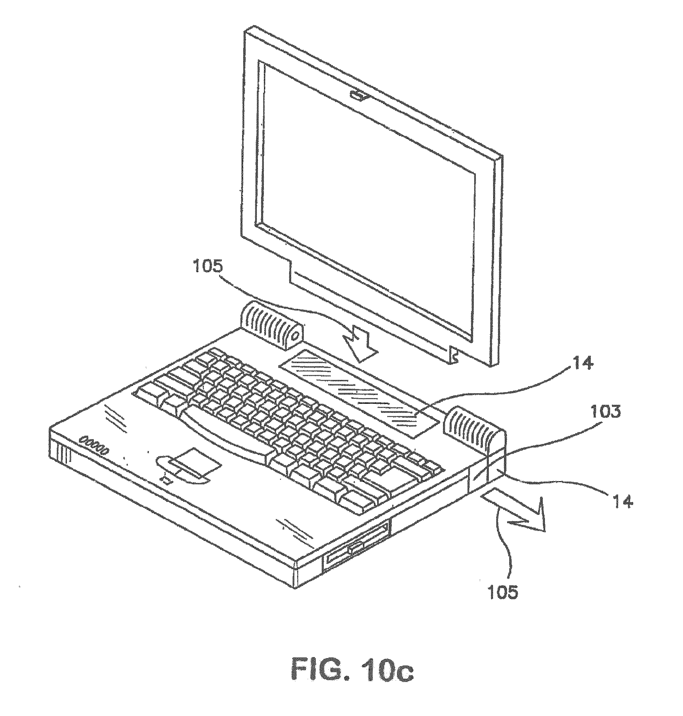

A particularly useful embodiment of the present invention comprises the use of the inventive protective cover assembly in an electronic device that requires forced air cooling. Figure 10a shows an electronic device 100 comprising a protective cover assembly 14, apertures 101, fan 103 and other critical electronic components 104. The protective cover assembly 14 is disposed over the fan 103 to ensure adequate protection from the environment (i.e., dust, dirt, and common fluids) while also allowing reasonable air flow 105 (i.e., low air flow resistance) necessary to cool the critical electronic components 104. Those skilled in the art will realize that a different arrangement of the various components may be possible that still utilizes the protective cover assembly 14 to protect critical electronic components 104. Examples of devices that use a protective cover assembly 14 that would require natural or forced air to cool electrical components include digital projectors and notebook computers, which are shown in Figure 10b and Figure 10c, respectively, having reference numerals designating the same features as described above.

FIG. 2 shows an external front view of a conventional cellular phone housing 10 having small apertures 11 covering a microphone location 12 and loudspeaker 13a and alert 13b locations. The number, size and shape of the apertures may vary greatly. Aperture designs include slots, ovals, circles, or other combinations of shapes.

FIG. 3 is an internal rear view of the housing 10 illustrating the same microphone location 12 and the loudspeaker and alert locations 13a and 13b. In addition, FIG. 3 illustrates generally a typical mounting location for protective cover assemblies 14 which are mounted in the microphone location 12 and the speaker and alert locations 13a and 13b.

FIGS. 4a and 4b illustrate a protective cover assembly 14 with a means for mounting to a housing 10 (not shown). In this example, an adhesive mounting system 24 is shown bonded to metal foil 20 with perforations 21 and treatment 25 (not shown). The adhesive mounting system 24 can be selected from many known materials well known in the art, such as thermoplastic, thermosetting, pressure-sensitive, or a reaction curing type, in liquid or solid form, selected from the classes including, but not limited to, acrylics, polyamides, polyacrylamides, polyesters, polyolefins, polyurethanes, polysilicons and the like. A pressure-sensitive adhesive mounting system 24 is most preferred, since it does not require heat or curing for mounting. The adhesive mounting system 24 can be applied directly to the metal foil 20 by screen printing, gravure printing, spray coating, powder coating, or other processes well known in the art. The adhesive mounting system 24 may be applied to the metal foil 20 in patterns, such as the ring-like shape shown in FIGS. 4a and 4b, continuously, using individual points, or in other patterns. For very large acoustic cover assemblies 14 it may be more convenient to use widely separated bond lines instead of discrete bond points. The need for additional bonding points of the protective cover assembly 14 is dependent on the shape of the area or device to be covered as well as by the size of the protective cover assembly 14. Thus, some experimentation may be needed to establish the best method and pattern of additional bonding to optimize acoustic performance of the cover assembly 14. In general for a given protective cover assembly, to reduce its acoustic impedance and associated acoustic loss of its system, the area of the open unbonded region(s) or the area with open pores, should be maximized. Additionally, the adhesive mounting system 24 may also comprise a carrier (not shown), such as a mesh or film, to facilitate application of adhesive mounting system 24 onto metal foil 20.

The adhesive mounting system 24 is simply a convenient means to mount the protective cover assembly 14 to the housing 10. Other means for mounting the protective cover assembly 14 to the housing 10 without the use of adhesives include heat staking, ultrasonic welding, press-fits, insert-molding, etc., which are processes well known in the art.

Other protective cover assembly 14 mounting systems follow in FIGS. 5a-9b.

FIGS. 5a and 5b illustrate an acoustically transparent "sandwich construction" embodiment of a protective cover assembly 14 of the present invention. A "sandwich construction" describes the configuration of the protective cover assembly 14, where a metal foil 20 with perforations 21 and treatment 25 is generally "sandwiched" between a first adhesive support system 22 and a second adhesive support system 24. The adhesive support systems 22 and 24 are preferably bonded so that an inner unbonded region of the metal foil 20 surrounded by an outer bonded region is formed. In the unbonded region of the metal foil 20, the combination of the two adhesive support systems 22 and 24 provides focused acoustic energy between a transducer and the housing 10, resulting in lower acoustic loss.

FIGS. 6a and 6b illustrate an embodiment of a "sandwich construction" protective cover assembly 14 as shown in FIGS. 5a and 5b, wherein an acoustic gasket 34 is bonded to the first adhesive mounting system 22. In this embodiment, the first adhesive mounting system 22 is a double-sided adhesive. The acoustic gasket 34 is attached to the first adhesive mounting system 22 and is designed to be compressed between a housing 10 and the acoustic transducer or PCB (not shown), so as to provide a seal and thus avoid acoustic leakage, as discussed in U.S. Patent Nos. 6,512,834. Conventional commercially-available materials are known in the art and are suitable for use as the acoustic gasket 34 material. For example, soft elastomeric materials or foamed elastomers, such as silicone rubber and silicone rubber foams, can be used. A preferred acoustic gasket 34 material is a microporous PTFE material, and more preferably, a microporous ePTFE having a microstructure of interconnected nodes and fibrils, as described in U.S. Patent Nos. 3,953,566, 4,187,390, and 4,110,392, which are incorporated herein by reference. Most preferably, the acoustic gasket 34 material comprises a matrix of microporous PTFE, which may be partially filled with elastomeric materials. These types of gaskets can offer thin profiles while also providing very low compression forces. Other types of acoustic gasket 34 materials might include a metal-plated or particle-filled polymer that provides features such as conformability and electrical conductivity. The acoustic gasket 34 can be bonded to the cover materials using the methods and materials for bonding together the metal foil 20 and adhesive mounting systems 22 and 24.

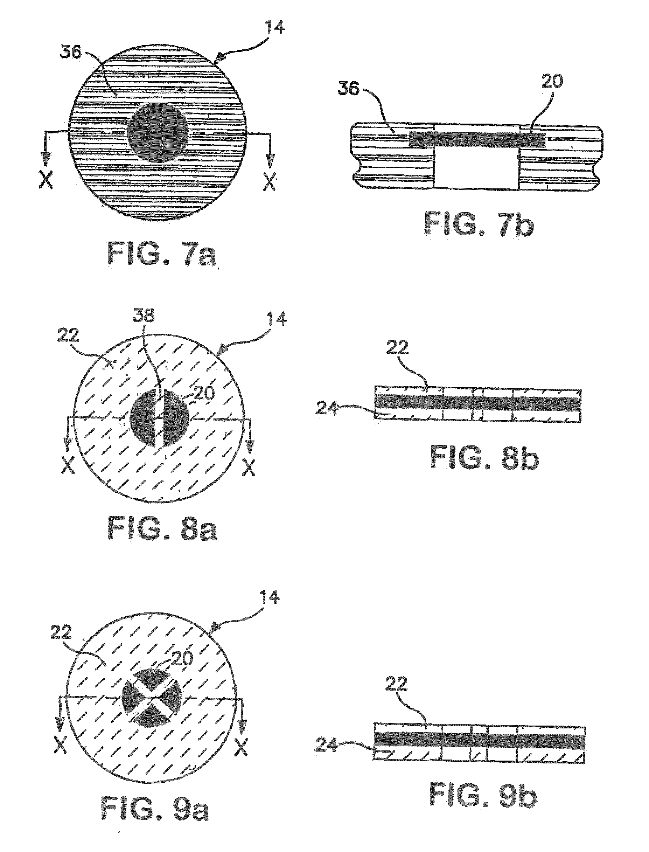

FIGS. 7a and 7b illustrate an alternative embodiment of a protective cover assembly 14 where the metal foil 20 with perforations 21 and treatment 25 is insert-molded into a plastic cap 36. Vulcanizable plastics, like silicones or natural rubber, and thermoplastics, like polypropylene, polyethylene, polycarbonates or polyamides, as well as thermoplastic elastomers, like Santoprene® or Hytrel®, are particularly suitable as a material for the plastic cap 36, though many other plastic materials may be used as well. Most of these plastics can be used in the so-called insert-molding injection-molding process, which offers the significant advantage of integrating a metal foil 20 into a plastic cap 36 in one step. This type of process can offer high bond strength while also providing cost benefits. The metal foil 20, owing to its high temperature resistance, is particularly compatible with such an insert-molding process without damage to it. Although the metal foil 20 is illustrated as being molded in the middle of the plastic cap 36, it should be understood that other locations and techniques are possible (i.e. the metal foil 20 may be molded into a groove formulated in any vertical position on the cap 36.)

FIGS. 8a, 8b, 9a and 9b are also "sandwich construction" embodiments as described above in all aspects, except that a supplemental bonding site 38 within the adhesive mounting system 22 and 24 spans across the metal foil 20. The supplemental bonding site 38 provides support for a protective cover assembly 14 with a relatively large inner unbonded region as discussed above. Although the supplemental bonding site 38 shown in the example has a defined geometry it should be noted that alternative supplemental bonding site geometries are possible and will be well understood by those skilled in the art.

## TEST METHODS

(1) Specific Acoustic Impedance

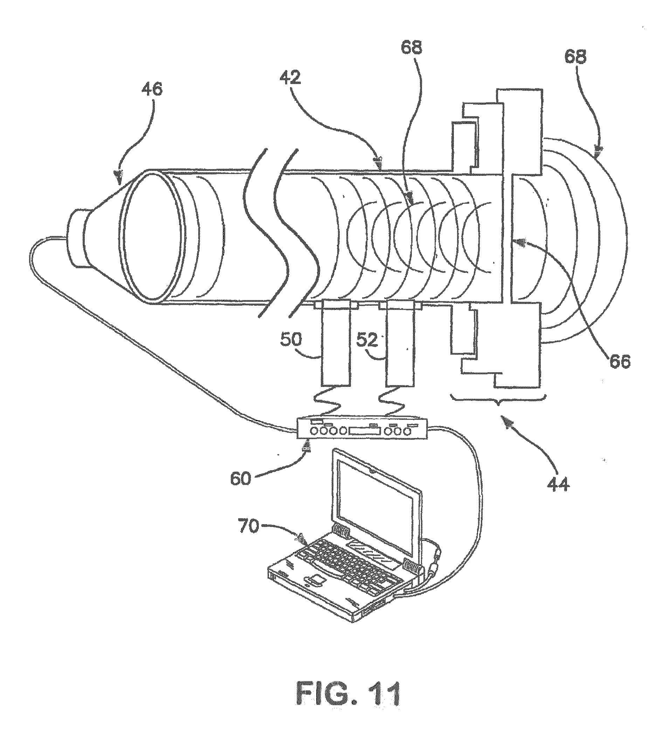

Samples were tested and evaluated using the analysis procedures and methodology as described in ASTM E 1050-90, (Standard Test Method for Impedance and Absorption of Acoustical Materials Using a Tube, Two Microphones, and a Digital Frequency Analysis System). However, a modification to the ASTM standard was required to accurately evaluate the protective cover assembly 14 and other competitive protective cover material samples. These modifications to the ASTM standard will be more readily understood and apparent when read in conjunction with the following description and while viewing accompanying drawings of the test sample holder in FIG. 11.

The primary exception to ASTM 1050-90 is the use of a test specimen holder 44 that has an open-end termination instead of a closed-end termination. The open-end termination measurement is utilized to closely represent acoustic systems used in typical electronic devices and is more accurate when measuring thin, porous products.

Initially, the test specimen holder 44 is installed on the impedance tube 42 without a sample 66. A computer 70 communicates with the function generator/analyzer 60 which generates white noise and drives the speaker 46. Sound waves 68 from the speaker 46 propagate down the impedance tube 42. At the end of the test specimen holder 44, some sound waves 68 reflect back and microphones 50 and 52 measure the transfer function at the location where a sample is normally positioned. From the transfer function, the specific acoustic impedance is measured. This impedance measurement without a sample 66 is then saved in a computer 70 for post processing. Upon completion of the test, a sample 66 is placed into the test specimen holder 44 and the impedance test is again performed. The original impedance is then simply subtracted from measured impedance of the sample to acquire the specific acoustic impedance of the sample 66. This is calculated using the specific acoustic impedance equation delineated in ASTM 1050-90 in conjunction with the following equation:

$$Z_{sample-radiation} = Z_{with\ sample} - Z_{radiation}$$

This procedure for measurement provides an accurate and simple metric for comparing the specific acoustic impedance of a sample. The results can also be evaluated at a particular discrete or range of frequencies to determine any acoustic impendance frequency dependence within the material.

Additionally, the specific acoustic resistance $Rs$ can be derived from the "complex" specific acoustic impedance Z by extracting the "real" part. Alternatively, extracting the "imaginary" part of the acoustic impedance will yield the specific acoustic reactance $Xs$, which is often displayed as a magnitude (i.e. values displayed are positive numbers). For protective cover assemblies 14 outlined herein and other protective covers that are highly porous, the specific acoustic resistance Rs will typically dominate the specific acoustic impedance. For non-porous protective covers or those with very tight pore structures, the specific acoustic reactance $Xs$ will dominate the specific acoustic impedance. Both components are useful in determming acoustic performance, although the specific acoustic resistance may be more representative when measuring highly porous protective covers.

(2) Instantaneous Water Entry Pressure ("I-WEP")

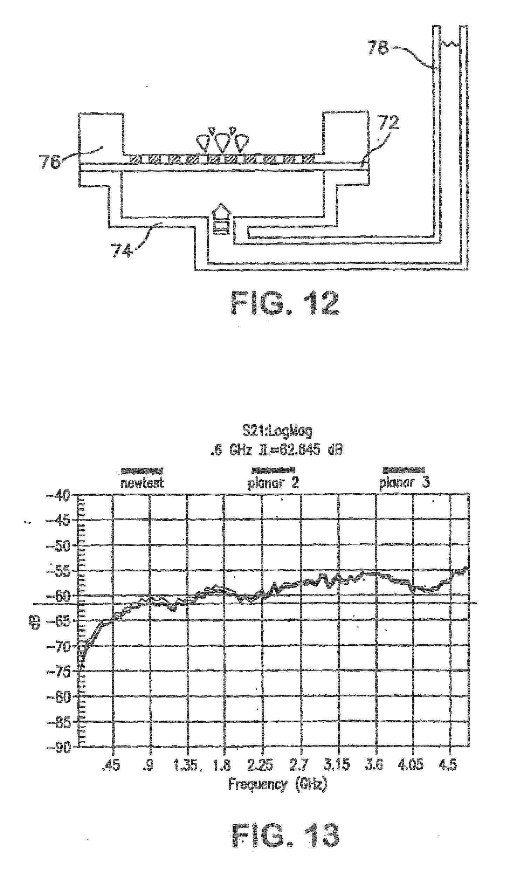

Instantaneous Water Entry Pressure ("I-WEP") provides a test method for water intrusion through highly porous materials. I-WEP is a measure of the sample's repellency or ability to serve as an aqueous barrier. This is an important property to consider and measure when designing electronic devices for water resistance applications. An illustration of the test device used to quantify I-WEP performance is shown in FIG. 12.

Initially, the test sample 72 is placed over the pressure cup 74. The clamping screen 76 is then secured and sealed to the pressure cup 74 to hold the sample securely in place. The water pressure in the pressure cup 74 is then gradually increased at a constant rate of 2.5 cm/second by way of a water column 78 until evidence of water breakthrough occurs. The water pressure at breakthrough is then recorded as the I-WEP.

(3) Average Maximum Pore Size

Using an optical microscope with micron-sized measurement capabilities and a backlight, ten random pores within a sample are visually inspected and the largest opening within the pore is measured and recorded. These ten values are then averaged to give an average maximum pore size.

(4) Air Flow Resistance

The air flow resistance of samples was determined by using the Model 8160 Automated Filter Tester ("AFT"), manufactured by TSI and conducted in accordance with the procedure described in ASTM Test Method D726-58. The AFT is an automated filter that measures filter efficiency and penetration versus particle size as well as air flow resistance for air filtration media. The AFT determines the air flow resistance by measuring the pressure drop or pressure differential across the test specimen. The results are reported in millimeters of $H_2O$ for a given flow rate of 25 liters/min and a face velocity of 5.34 cm/s.

(5) EMI shielding effectiveness

The EMI shielding effectiveness of the samples were measured in accordance with ASTM D4935-99, "Standard Method for Measuring the Electromagnetic Shielding Effectiveness of Planar Materials".

**Example 1**

Hydrophobic Perforated Nickel Foil

A perforated nickel foil manufactured by Stork Veco B.V. was provided comprising the following nominal properties: thickness-0.0005" (12 micrometers); average maximum pore size - 87 micrometers; percent open area -45%. A disc, 35mm diameter, was cut from the material. A treatment was prepared using Teflon AF fluoropolymer from DuPont. The treatment consisted of 0.15% by weight of the Teflon AF in 99.85% by weight solvent, which was TF5070 from 3M. An adequate amount of coating solution was poured into a petri dish and the foil was fully immersed using tweezers. The treated foil was subsequently suspended in a fume hood for approximately 10 minutes. Specific acoustic resistance and reactance, along with I-WEP, and air flow resistance were tested according to the test methods outlined above. A comparison of the results from these tests are shown in Table 1 along with the material properties of thickness, and average maximum pore size.

**Comparative Example 1**

Hydrophobic Porous Woven Protective Covermade with Polyester

This example is a commercially available protective cover sold under the tradename SAATIFIL ACOUSTEX™ B010 by SaatiTech, a division of the Saati Group, Inc. The product consists of a polyester woven material. The material had the following nominal properties: thickness-105 micrometers; average maximum pore size -120 micrometers; percent open area - 41 %. A disc, 35mm diameter, was cut from the material. Specific acoustic resistance and reactance, along with I-WEP, and air flow resistance were tested as described above. A comparison of the results from these tests are shown in Table 1 along with the material properties of thickness, and average maximum pore size.

**Comparative Example 2**

Hydrophobic Porous Non-woven Protective Covermade with Polyester

This example is a commercially available protective cover sold under the tradename GORE™ PROTECTIVE COVER GAW101 manufactured by W. L. Gore & Associates, Inc. The product consists of a black, non-woven cellulose material. The material had the following nominal properties: thickness-150 micrometers; average maximum pore size - 56 micrometers. A disc, 35mm diameter, was cut from the material. Specific acoustic resistance and reactance, along with I-WEP, and air flow resistance were tested as described above. A comparison of the results from these tests are shown in Table 1 along with the material properties of thickness, and average maximum pore size.

**Comparative Example 3**

Microporous PTFE Protective Cover

This example is a commercially available protective cover sold under the tradename GORE™ PROTECTIVE COVER GAW314 manufactured by W. L. Gore & Associates, Inc. The product consists of a black, ePTFE based material. The material had the following nominal properties thickness-11 micrometers; average maximum pore size - 0 45 micrometers A disc, 35mm diameter, was cut from the material Specific acoustic resistance and reactance, along with I-WEP, and air flow resistance were tested as described above. A comparison of the results from these tests are shown in Table 1 along with the material properties of thickness, and average maximum pore size.

Table 1

**TABLE 1**

| Examples | Average Specific Acoustic Impedance from 250 to 300 Hz (MKS Rayls) | | Average Instantaneous Water Entry Pressure | Other Nominal Properties | | |
|---|---|---|---|---|---|---|
| | Resistance (magnitude) | Reactance (magnitude) | I-WEP (cm) | Airflow Resistance (mm of $H_2O$) | Thickness ($\mu$m) | Avg. Max Pore Size ($\mu$m) |
| Example 1 | 9 | 0 | 20 | 0.05 | 12 | 90 |
| Comparative 1 | 11 | 1 | 11 | 0.05 | 105 | 158 |
| Comparative 2 | 64 | 7 | 15 | 0.26 | 150 | 56 |
| Comparative 3 | 5 | 86 | >300 | 160.5 | 20 | 045 |

As can be seen from Table 1, the exemplary embodiment of this invention illustrated by Example 1, has improved average acoustic impedance over all of the Comparative Examples, which includes no measurable reactance Example 1 shows equivalent air flow resistance with Comparative Example 1, but at a smaller maximum pore size, thereby providing a higher level of particulate protection Example 1 provides these improvements while still maintaining a high level of water entry protection, sufficient for most portable device applications, for example a digital projector or notebook computer If necessary, the water entry protection of Example 1 could be even further improved using other coating treatments described herein. Example 1 has the further advantages over the Comparative Examples of being electrically conductive, and compatible with standard insert molding processes In addition, a further advantage of the exemplary embodiment is its EMI shielding effectiveness, which is shown in Figure 13 to be at least 50 dB, from 0 to 4 Gigahertz.

**Claims**

1. A protective cover assembly (14) comprising:

    (i) a metal foil (20) with perforations (21), and
    (ii) a hydrophobic and/or oleophobic treatment (25) on one or more surfaces of said metal foil (20),
    wherein said protective cover assembly (14) has an average specific acoustic resistance of less than about 64 Rayls MKS (64 Ns/m$^2$) from 250-300 Hz, conducted in accordance with the analysis procedures and methodology as described in ASTM E 1050-90, but modified by using a test specimen holder having an open-end termination instead of a closed-end termination.

2. The protective cover assembly (14) of claim 1, wherein said protective cover assembly (14) has an average specific acoustic resistance of less than about 11 Rayls MKS (11 Ns/m$^2$) from 250-300 Hz.

3. The protective cover assembly (14) of claim 1, wherein said protective cover assembly (14) has an average specific acoustic reactance magnitude of less than about 7 Rayls MKS (7 Ns/m$^2$) from 250-300 Hz.

4. The protective cover assembly (14) of claim 1, wherein said protective cover assembly (14) has an average specific acoustic reactance magnitude of less than about 1 Rayls MKS (1 Ns/m$^2$) from 250-300 Hz.

5.  The protective cover assembly (14) of claim 1, wherein said protective cover assembly (14) has an instantaneous water entry pressure value of greater than about 11 cm.

6.  The protective cover assembly of claim 1 wherein said perforations (21) have an average maximum pore size of less than about 150 micrometers.

7.  The protective cover assembly (14) of claim 1 further comprising an adhesive mounting system (24).

8.  The protective cover assembly (14) of claim 1 wherein said metal foil (20) is nickel.

9.  An apparatus comprising:

    (a) an electronic component;
    (b) a housing (10) having at least one aperture, the housing (10) at least partially enclosing the electronic component; and
    (c) a protective cover assembly (14) according to any of claims 1 to 8 disposed proximate the electronic component.

10. An apparatus according to claim 9, wherein the protective cover assembly (14) is integral with the housing (10).

11. An apparatus according to claim 9 or 10, wherein the electronic component is an acoustic transducer.

12. A method for protecting an electronic component disposed in a housing (10) having an aperture by:

    (a) providing a protective cover assembly (14) according to any of claims 1 to 8;
    (b) mounting the protective cover assembly (14) proximate the electronic component to protect the electronic component from particulates and liquid ingress.

**FIG. 1a**

**FIG. 1b**

**FIG. 2**

**FIG. 3**

FIG. 4a

FIG. 4b

FIG. 5a

FIG. 5b

FIG. 6a

FIG. 6b

EP 2 741 522 A1

FIG. 7a

FIG. 7b

FIG. 8a

FIG. 8b

FIG. 9a

FIG. 9b

17

FIG. 10a

FIG. 10b

FIG. 10c

FIG. 11

**FIG. 12**

S21:LogMag
.6 GHz IL=62.645 dB

**FIG. 13**

Europäisches Patentamt
European Patent Office
Office européen des brevets

# EUROPEAN SEARCH REPORT

Application Number

EP 14 15 7892

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 02/45463 A (KNOWLES ELECTRONICS LLC [US]) 6 June 2002 (2002-06-06)<br>* figure 7 *<br>* page 1, line 26 - page 2, line 2; claim 32 *<br>* page 6, line 19 - line 30 *<br>* page 7, lines 1-8 *<br>* page 11, line 19 - line 20 *<br>----- | 1-12 | INV.<br>H04R1/00<br><br>ADD.<br>H04R1/08<br>H04R1/02 |
| A,D | US 5 342 434 A (WU HUEY S [US]) 30 August 1994 (1994-08-30)<br>* column 1, line 14 - line 17 *<br>* column 2, line 1 - line 16 *<br>* column 2, line 19 - line 33 *<br>* column 3, line 47 - line 50 *<br>----- | 1-12 | |
| A | US 6 018 585 A (AKINO HIROSHI [JP] ET AL) 25 January 2000 (2000-01-25)<br>* the whole document *<br>----- | 1-12 | |
| A,D | US 6 512 834 B1 (BANTER CHAD ANTHONY [US] ET AL) 28 January 2003 (2003-01-28)<br>* abstract *<br>* column 2, line 25 - line 36 *<br>* column 10, line 1 - column 11, line 40 *<br>* table 1 *<br>* column 6, line 31 - line 54 *<br>----- | 1-12 | **TECHNICAL FIELDS SEARCHED (IPC)**<br><br>H04R |
| T | "Standard Test Method for Impedance and Absorption of Acoustical Materials Using a Tube, Two Microphones, and a Digital Frequency Analysis System",<br>ASTM INTERNATIONAL,<br>no. Designation: E 1050-90,<br>1 January 1990 (1990-01-01), pages 1-6,<br>XP007922614,<br>* the whole document *<br>----- | | |

The present search report has been drawn up for all claims

| Place of search | Date of completion of the search | Examiner |
|---|---|---|
| Munich | 3 April 2014 | Guillaume, Mathieu |

EPO FORM 1503 03.82 (P04C01)

## ANNEX TO THE EUROPEAN SEARCH REPORT
## ON EUROPEAN PATENT APPLICATION NO.

EP 14 15 7892

This annex lists the patent family members relating to the patent documents cited in the above-mentioned European search report.
The members are as contained in the European Patent Office EDP file on
The European Patent Office is in no way liable for these particulars which are merely given for the purpose of information.

03-04-2014

| Patent document cited in search report | | Publication date | Patent family member(s) | | Publication date |
|---|---|---|---|---|---|
| WO 0245463 | A | 06-06-2002 | AT | 510415 T | 15-06-2011 |
| | | | AU | 2911602 A | 11-06-2002 |
| | | | EP | 1346601 A2 | 24-09-2003 |
| | | | EP | 2249583 A2 | 10-11-2010 |
| | | | JP | 4532827 B2 | 25-08-2010 |
| | | | JP | 5216717 B2 | 19-06-2013 |
| | | | JP | 2004537182 A | 09-12-2004 |
| | | | JP | 2008099271 A | 24-04-2008 |
| | | | JP | 2009296630 A | 17-12-2009 |
| | | | US | 2002102004 A1 | 01-08-2002 |
| | | | US | 2005185812 A1 | 25-08-2005 |
| | | | US | 2007082421 A1 | 12-04-2007 |
| | | | WO | 0245463 A2 | 06-06-2002 |
| US 5342434 | A | 30-08-1994 | FR | 2699185 A1 | 17-06-1994 |
| | | | US | 5342434 A | 30-08-1994 |
| US 6018585 | A | 25-01-2000 | JP | 3629084 B2 | 16-03-2005 |
| | | | JP | H09205693 A | 05-08-1997 |
| | | | US | 6018585 A | 25-01-2000 |
| US 6512834 | B1 | 28-01-2003 | AU | 5923900 A | 22-01-2001 |
| | | | CA | 2377726 A1 | 11-01-2001 |
| | | | DE | 60021079 D1 | 04-08-2005 |
| | | | DE | 60021079 T2 | 18-05-2006 |
| | | | EP | 1197119 A2 | 17-04-2002 |
| | | | JP | 2003503991 A | 28-01-2003 |
| | | | JP | 2008245332 A | 09-10-2008 |
| | | | JP | 2009303279 A | 24-12-2009 |
| | | | JP | 2011142680 A | 21-07-2011 |
| | | | JP | 2013102555 A | 23-05-2013 |
| | | | JP | 2014030277 A | 13-02-2014 |
| | | | US | 6512834 B1 | 28-01-2003 |
| | | | WO | 0103468 A2 | 11-01-2001 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 686036 A
- US 4949386 A
- US 4987597 A
- US 5420570 A
- US 4071040 A
- US 5828012 A
- US 6512834 B
- US 4844778 A
- US 5116650 A

- US 5286279 A
- US 5342434 A
- US 5376441 A
- US 5385694 A
- US 5460872 A
- US 5462586 A
- US 3953566 A
- US 4187390 A
- US 4110392 A